# EUROPEAN PATENT SPECIFICATION

(11) **EP 0 308 274 B1**
(45) Date of publication and mention of the grant of the patent: **24.08.1994**
(21) Application number: 88308663.9
(22) Date of filing: 19.09.1988
(51) Int. Cl.: G03F 7/028

(54) **Process for coating a substrate**
Verfahren zur Beschichtung eines Substrates
Procédé pour enduire un support

(30) Priority: 18.09.1987 US 98358
(43) Date of publication of application: 22.03.1989
(73) Proprietor: THE MEAD CORPORATION, Dayton Ohio 45401-1817 (US)
(72) Inventor: Gottschalk, Peter, Centerville Ohio 45459 (US); Schuster, Gary B., Champaign Illinois 61821 (US); Neckers, Douglas C., Perrysburg Ohio (US)
(74) Representative: Deans, Michael John Percy

(56) References cited:
- EP-A- 164 931
- EP-A- 0 223 587
- GB-A- 2 113 860
- US-A- 4 725 530
- US-A- 4 842 980

## Description

This invention relates to processes for coating a substrate, and in particular for forming coatings without tint on a substrate. By coatings without tint we mean colourless, clear or transparent coatings and white coatings.

European Patent Specification EP-A-0223587 is concerned with full colour imaging systems and with photohardenable compositions and photosensitive materials employing them, which are designed to be used in such systems, in which an encapsulated (usually microencapsulated) radiation sensitive composition associated with an image-forming agent (for example a colour precursor) is image-wise exposed to radiation which usually hardens the composition, and then subjected to a uniform rupturing force to release the colour precursor in an image-wise pattern to form a colour by reaction with a developer. The photocurable compositions described in EP-A-0223587 contain ionic dye complexes as photoinitiators. These complexes directly or indirectly yield free radicals upon exposure to actinic radiation and particularly visible light. By nature, compositions such as these which are sensitive to visible light appear coloured to the human eye.

A coloured appearance in a cured composition is a drawback in certain applications where such a system might otherwise be advantageous. For example, in laminating glass, if the composition is coloured it imparts a tint to the glass which is generally undesirable. Similarly, in coating optical fibres a coloured appearance is a drawback.

We have now appreciated that photobleachable ionic dye complexes would be particularly useful in such applications. We have observed that some of the dyes disclosed in the aforementioned EP-A-0223587 are photobleachable. The present invention may thus be seen at least in part as a selection from what is described in the said European Application applied to a novel use.

The present invention provides a process for coating a substrate with a coating which is essentially without tint comprising the steps of: coating said substrate with a visible light sensitive composition comprising a free radical addition polymerizable or crosslinkable material and a photobleachable ionic dye-counter ion compound capable of absorbing visible light and generating free radicals, said ionic dye counter ion compound being a cationic dye-borate anion compound represented by the formulas (I): 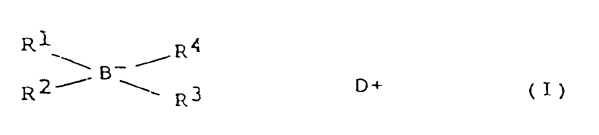
where D is a cationic dye moiety; and R¹, R², R³ and R⁴ are the same or different and selected from alkyl, aryl, aralkyl, alkaryl, alkenyl, alkynyl, alicyclic, heterocyclic, and allyl groups; exposing said composition to light to harden said composition; and bleaching said ionic dye to an essentially colourless state.

Our process is useful in applications in which an essentially colourless, clear or transparent coating is desired. Typical examples of such applications are in laminating glass or coating optical fibres. Our process is also useful in coating using compositions containing white pigments such as titanium dioxide, where no tint is desired.

Ionic dye complexes useful in the practice of the present invention are included within the general description of EP-A-0223587.

The ionic dye complexes useful in the present invention are characterised in that they are photobleachable.

The polymerizable or crosslinkable materials described in the aforementioned applications are useful herein. The photoinitiator systems described in the aforementioned applications are also useful herein with the requirement that the ionic dye-counter ion compounds be photobleachable. Of the dye complexes disclosed in EP-A-0223587, all of the cyanine dye complexes are photobleachable with varying efficiency and speed. Some of the more efficient photobleachable complexes are: 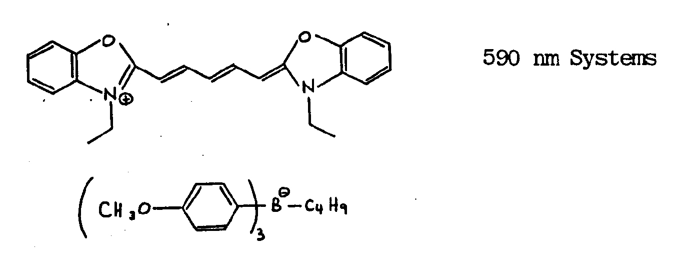 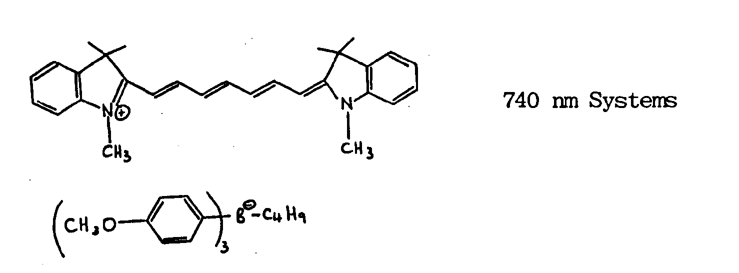
The azine dye complex of Methylene Blue and triphenylbutylborate is one of the most efficient complexes in terms of photobleachability. Its structure is

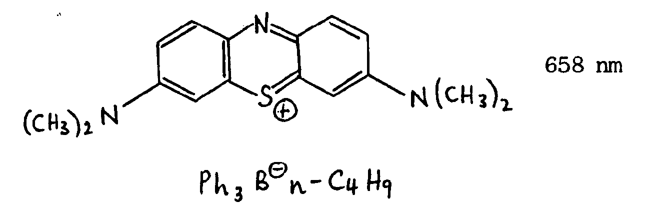

For the purpose of the present invention, the photobleachable dye complexes may bleach upon exposure to visible light upon curing the compositions, or they may be bleached upon post-exposure to a bleaching radiation such as ultraviolet radiation.

## Claims

1. A process for coating a substrate with a coating which is essentially without tint comprising the steps of: coating said substrate with a visible light sensitive composition comprising a free radical addition polymerizable or crosslinkable material and a photobleachable ionic dye-counter ion compound capable of absorbing visible light and generating free radicals, said ionic dye counter ion compound being a cationic dye-borate anion compound represented by the formula (I): 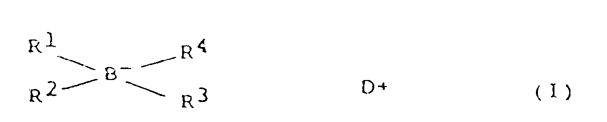 where D is a cationic dye moiety; and R¹, R², R³ and R⁴ are the same or different and selected from alkyl, aryl, aralkyl, alkaryl, alkenyl, alkynyl, alicyclic, heterocyclic, and allyl groups; exposing said composition to light to harden said composition; and bleaching said ionic dye to an essentially colourless state.

2. A process according to Claim 1, further characterised in that said bleaching step takes place in the course of said exposure to light step to harden the composition.

3. A process according to Claim 1, further characterised in that said bleaching step comprises exposure to a bleaching radiation such as ultra-violet radiation post exposure to said visible light.

4. A process according to any preceding claim, further characterised in that, prior to exposure, said photobleachable ionic dye-counter ion compound is a stable, non-transient compound.

5. A process according to any preceding claim, further characterised in that said photobleachable ionic dye-counter ion compound is soluble in said free radical addition polymerizable or crosslinkable compound.

6. A process according to any preceding claim, further characterised in that, following exposure of said ionic dye-counter ion compound to light, an electron is transferred from said dye to said counter ion or from said counter ion to said dye, the rate of said electron transfer being greater than a diffusion controlled rate.

7. A process according to any preceding claim, further characterised in that said cationic dye is selected from cationic methine, polymethine, triarylmethane, indoline, azine, thiazine, xanthene, oxazine, acridine, cationic cyanine, carbocyanine, hemicyanine, rhodamine, and azamethine dyes.

8. A process according to Claim 7, further characterised in that at least one of R¹, R², R³ and R⁴ is an alkyl group.

9. A process according to Claim 8, further characterised in that R¹, R², and R³ are aryl groups and R⁴ is an alkyl group.

10. A process according to Claim 7, further characterised in that said dye is Methylene Blue.

11. A process according to Claim 7, further characterised in that said cationic dye is selected from 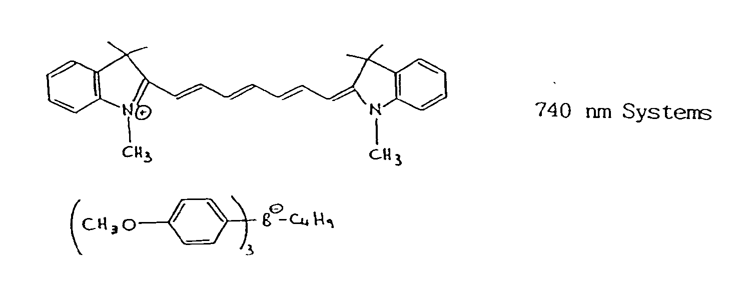 and

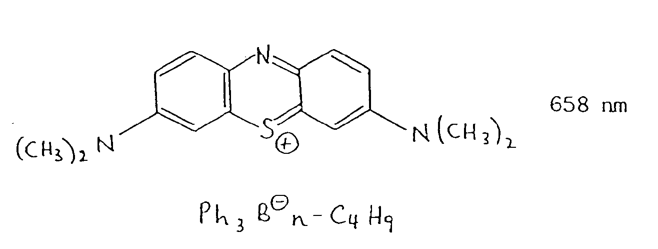

12. A process according to any preceding claim, further characterised in that said polymerizable or crosslinkable material contains an ethylenically unsaturated compound.

13. A process according to any preceding claim, further characterised in that said substrate is glass.

14. A process according to any of Claims 1-12, further characterised in that said substrate is an optical fibre.

## Patentansprüche

1. Verfahren zur Beschichtung eines Substrates mit einer im wesentlichen farblosen Beschichtung, welches die folgenden Verfahrensschritte umfaßt:
- Beschichten des Substrates mit einer auf sichtbares Licht ansprechenden Zusammensetzung, die ein durch frei radikalische Addition polymerisierbares oder vernetzbares Material sowie eine lichtbleichbare Verbindung aus ionischem Farbstoff und Gegenion umfaßt, welche zur Absorption sichtbaren Lichts und Erzeugung freier Radikale geeignet ist, wobei die genannte Verbindung aus ionischem Farbstoff und Gegenion eine Verbindung aus kationischem Farbstoff und Borat-Anion ist und durch die Formel 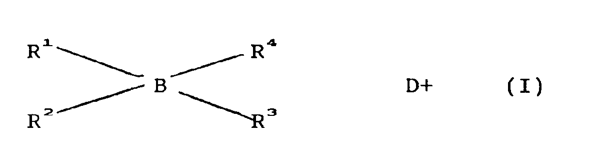 dargestellt wird, in der D ein kationischer Farbstoff- rest ist, und R1, R2, R3 und R4 untereinander gleich oder voneinander verschieden sind und aus der Menge der Alkyl-, Aryl-, Aralkyl-, Alkaryl-, Alkenyl-, Alkinyl-, alicyklischen, heterocyklischen und Allyl-Gruppen ausgewählt werden;
- Belichten der Zusammensetzung zum Härten derselben; und
- Bleichen des ionischen Farbstoffs bis zu einem im wesentlichen farblosen Zustand.

2. Verfahren nach Anspruch 1, dadurch gekennzeichnet, daß der Verfahrensschritt des Bleichens im Verlaufe des Verfahrensschrittes der Belichtung zum Härten der Zusammensetzung stattfindet.

3. Verfahren nach Anspruch 1, dadurch gekennzeichnet, daß der Verfahrensschritt des Bleichens die Einwirkung einer bleichenden Strahlung, wie zum Beispiel einer Ultraviolettstrahlung, nach der Belichtung mit sichtbarem Licht umfaßt.

4. Verfahren nach einem der vorangegangenen Ansprüche, dadurch gekennzeichnet, daß die Verbindung aus licht- bleichbarem ionischem Farbstoff und Gegenion vor der Belichtung eine stabile, langlebige Verbindung ist.

5. Verfahren nach einem der vorangegangenen Ansprüche, dadurch gekennzeichnet, daß die Verbindung aus lichtbleichbarem ionischem Farbstoff und Gegenion in der durch freie radikalische Addition polymerisierbaren oder vernetzbaren Verbindung löslich ist.

6. Verfahren nach einem der vorangegangenen Ansprüche, dadurch gekennzeichnet, daß nach der Belichtung der Verbindung aus ionischem Farbstoff und Gegenion ein Elektron vom Farbstoff auf das Gegenion bzw. vom Gegenion auf den Farbstoff übertragen wird, wobei die Rate der genannten Elektronübertragung größer ist als eine durch Diffusion gesteuerte Übertragungsrate.

7. Verfahren nach einem der vorangegangenen Ansprüche, dadurch gekennzeichnet, daß der kationische Farbstoff aus der Gruppe der kationischen Methin-, Polymethin-, Triarylmethan-, Indolin-, Azin-, Thiazin-, Xanthen-, Oxazin-, Acridin-, kationischem Cyanin-, Carbocyanin-, Hemicyanin-, Rhodamin- und Azamethinfarbstoffe ausgewählt wird.

8. Verfahren nach Anspruch 7, dadurch gekennzeichnet, daß mindestens eine der R1-, R2-, R3- und R4-Gruppen eine Alkylgruppe ist.

9. Verfahren nach Anspruch 8, dadurch gekennzeichnet, daß R1, R2 und R3 Arylgruppen sind und R4 eine Alkylgruppe ist.

10. Verfahren nach Anspruch 7, dadurch gekennzeichnet, daß der Farbstoff Methylenblau ist.

11. Verfahren nach Anspruch 7, dadurch gekennzeichnet, daß der kationische Farbstoff entweder 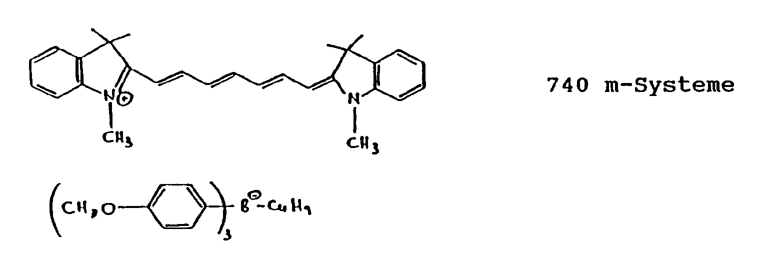 oder 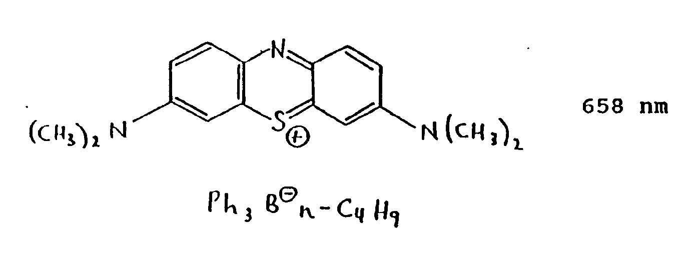 ist.

12. Verfahren nach einem der vorangegangenen Ansprüche, dadurch gekennzeichnet, daß das polymerisierbare oder vernetzbare Material eine ethylenisch ungesättigte Verbindung enthält.

13. Verfahren nach einem der vorangegangenen Ansprüchen, dadurch gekennzeichnet, daß das Substrat Glas ist.

14. Verfahren nach einem der Ansprüche 1-12, dadurch gekennzeichnet, daß das Substrat eine Lichtleitfaser ist.

## Revendications

1. Procédé de revêtement d'un substrat d'un revêtement qui est essentiellement sans teinte, comprenant les étapes consistant à : revêtir ledit substrat d'une composition sensible à la lumière visible, comprenant un produit réticulable ou polymérisable par addition en présence de radicaux libres et un composé colorant ionique-contre ion photodécolorable, capable d'absorber la lumière visible et de produire des radicaux libres, ledit composé colorant ionique-contre ion étant un composé colorant cationique-anion borate représenté par la formule (I): 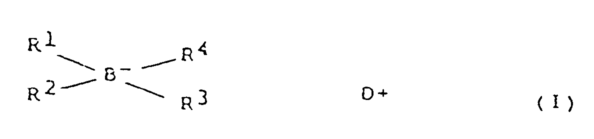 dans laquelle D est une fraction de colorant cationique ; et R¹, R², R³ et R⁴ sont identiques ou différents et sont choisis parmi des groupements alkyle, aryle, aralkyle, alkaryle, alcényle, alcynyle, alicyclique, hétérocyclique et allyle ; exposer ladite composition à la lumière afin de durcir ladite composition ; et décolorer ledit colorant ionique en un état sensiblement incolore.

2. Procédé selon la revendication 1, caractérisé de plus en ce que ladite étape de décoloration a lieu pendant ladite étape d'exposition à la lumière, destinée à durcir la composition.

3. Procédé selon la revendication 1, qui est de plus caractérisé en ce que ladite étape de décoloration comprend l'exposition à une radiation de décoloration comme une radiation ultraviolette après l'exposition à ladite lumière visible.

4. Procédé selon l'une quelconque des revendications précédentes qui est de plus caractérisé en ce que avant l'exposition, ledit composé colorant ionique-contre ion photodécolorable est un composé stable, non transitoire.

5. Procédé selon l'une quelconque des revendications précédentes qui est de plus caractérisé en ce que ledit composé colorant ionique-contre ion photo-décolorable est soluble dans ledit composé réticulable ou polymérisable par addition en présence de radicaux libres.

6. Procédé selon l'une quelconque des revendications précédentes qui est de plus caractérisé en ce qu'après les expositions dudit composé colorant ionique-contre ion à la lumière, un électron est transféré dudit colorant audit contre ion ou dudit contre ion audit colorant, la vitesse dudit transfert d'électron étant supérieure à une vitesse contrôlée par la diffusion.

7. Procédé selon l'une quelconque des revendications précédentes qui est de plus caractérisé en ce que, ledit colorant cationique est choisi parmi des colorants méthine cationique, polyméthine, triarylméthane, indoline, azine, thiazine, xanthène, oxazine, acridine, cyanine cationique, carbocyanine, hémicyanine, rhodamine et azaméthine.

8. Procédé selon la revendication 7, qui est de plus caractérisé en ce que l'un au moins parmi R¹, R², R³ et R⁴ est un groupement alkyle.

9. Procédé selon la revendication 8, qui est de plus caractérisé en ce que R¹, R² et R³ sont des groupements aryle et R⁴ est un groupement alkyle.

10. Procédé selon la revendication 7, qui est de plus caractérisé en ce que ledit colorant est du bleu de méthylène.

11. Procédé selon la revendication 7, qui est de plus caractérisé en ce que ledit colorant cationique est choisi parmi: 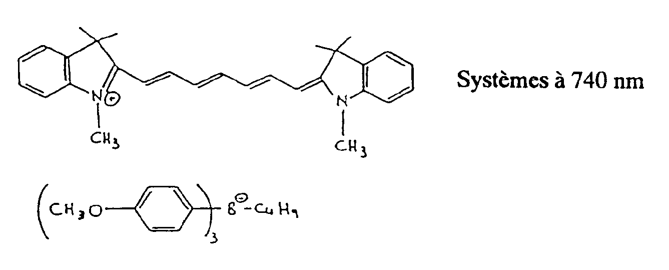 et

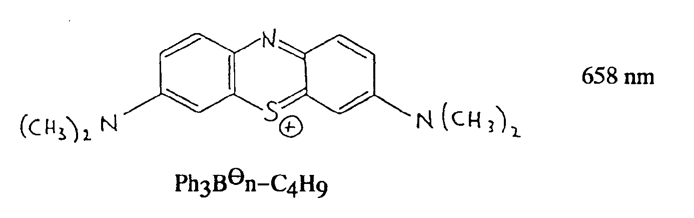

12. Procédé selon l'une quelconque des revendications précédentes, qui est de plus caractérisé en ce que ledit produit polymérisable ou réticulable contient un composé éthyléniquement insaturé.

13. Procédé selon l'une quelconque des revendications précédentes, qui est de plus caractérisé en ce que ledit substrat est du verre.

14. Procédé selon l'une quelconque des revendications 1 à 12, qui est de plus caractérisé en ce que ledit substrat est une fibre optique.
